Europäisches Patentamt

European Patent Office

Office européen des brevets

(11) Publication number: **0 216 756
B1**

# EUROPEAN PATENT SPECIFICATION

(45) Date of publication of patent specification: **07.03.90**

(51) Int. Cl.⁵: **H 03 K 19/0175**

(21) Application number: **84904268.4**

(22) Date of filing: **02.11.84**

(86) International application number:
**PCT/US84/01805**

(87) International publication number:
**WO 86/02792 09.05.86 Gazette 86/10**

(54) **INTEGRATED CIRCUIT DEVICE ACCEPTING INPUTS AND PROVIDING OUTPUTS AT THE LEVELS OF DIFFERENT LOGIC FAMILIES.**

(43) Date of publication of application:
**08.04.87 Bulletin 87/15**

(45) Publication of the grant of the patent:
**07.03.90 Bulletin 90/10**

(84) Designated Contracting States:
**AT BE CH DE FR GB LI LU NL SE**

(56) References cited:
**EP-A-0 023 118
US-A-3 959 666
US-A-3 986 045
US-A-4 135 103
US-A-4 368 395
US-A-4 472 647
US-A-4 477 740**
**ELECTRONICS INTERNATIONAL, vol. 51, no. 23, 9th November 1978, pages 107-112, New York, US; D. MRAZEK: "Bit-slice parts approach ECL speeds with TTL power levels"**
**TTL, MOS, LINEAR, OPTO, APPLICATIONS REPORTS FROM TEXAS INSTRUMENTS, 1971, pages 242-251, Schiphol, NL; J. TALLEY: "Monolithic interfacing in computers"**

(73) Proprietor: **ADVANCED MICRO DEVICES, INC.
901 Thompson Place P.O. Box 3453
Sunnyvale, CA 94088 (US)**

(72) Inventor: **THOMPSON, Michael, D.
18485 Main Boulevard
Los Gatos, CA 95030 (US)**

(74) Representative: **Wright, Hugh Ronald et al
Brookes & Martin High Holborn House 52/54
High Holborn
London WC1V 6SE (GB)**

(56) References cited:
**PATENT ABSTRACTS OF JAPAN, vol. 8, no. 181 (E-261)1618r, 2nd August 1984; & JP-A-59 72 822 (HITACHI DENSEN K.K.) 24-04-1984**
**WESCON TECHNICAL PAPER, vol. 26, September 1982, pages 1-7, North Hollywood, US; R. PITTS: "Advances in semicustom technology"**
**WESCON TECHNICAL PAPER, vol. 26, September 1982, pages 1-5, North Hollywood, US; R. NALESNIK: "A high performance ECL gate array family"**

EP  0 216 756  B1

(56) References cited:
PROCEEDINGS OF THE 1ST INTERNATIONAL
CONFERENCE, November 1981, London, Semi-
Custom ICs, edited by Milos Krejcik, published
in February 1982,pages 229-234, Mackintosh
Publications Ltd, Luton, GB; J.C. COWAY et al.:
"Computer aided design of gate arrays"

## Description

### Background of the Invention
### Field of the Invention

This invention relates to an integrated circuit device incorporating internal logic and/or memory circuitry and, more particularly, relates to an integrated circuit device which can accept inputs at the levels of different logic families and which can provide outputs at the levels of different logic families.

In the development of semiconductor devices, separate logic families have developed. Using bipolar processes, the following logic families have developed: transistor-transistor logic (TTL), integrated injection logic ($I^2L$) and emitter-coupled logic (ECL). Using metal oxide semiconductor fabrication processes, both MOS and CMOS logic families have developed. Each logic family has its own circuit building blocks and operating parameters including set reference voltage levels and specified ranges of voltages, the so-called "levels", which signify the digital information, e.g. whether a digital "1" or a digital "0" is to be signified by the state of the device. The conventional approach has been to design an integrated circuit using a particular logic family to carry out logic or memory functions. Thus, a CMOS circuit would have signals supplied to it which were suitable to match the internal signals within the device; the output would also have a CMOS format. Similarly, an ECL circuit would have input voltages within the ranges which would specify uniquely the information being provided; the output would also be supplied in an ECL format.

Transistor-transistor logic was one of the earliest logic families and has been widely adopted for integrated circuit design. It remains a very pervasive logic family. As a consequence, in order to obtain compatability with TTL circuits some circuits designed with logic families other than TTL are provided input translators and with output translators which make the circuits look like TTL circuits. For example, some CMOS circuits are made to appear as TTL circuits. Also, so-called pseudo-ECL devices have internal ECL circuitry yet look externally like TTL devices. The AMD 29116 Microprocessor and the AMD 29501 Programmable Signal Processor are pseudo-ECL devices. Such devices are effectively high performance TTL devices and do not allow different logic circuit families to be used together on the same circuit board.

As the level of integration and degree of sophistication of semiconductor devices has increased, circuit designers have selected their circuit building blocks from parts based on different logic families. This has been due to the availability of complex logic functions and/or dense memory arrays in all of these various logic families. As a consequence, it has been necessary to provide external translators which would translate, for example, the output of a TTL chip to an ECL voltage level so that an associated ECL chip would receive an input that it could recognize. The Signetics 10124 TTL to ECL translator is such a part. Conversely, the output of an ECL chip may have required translation to a TTL logic level for an input to a TTL chip.

Emitter-coupled logic (ECL) gates are widely utilized for high-speed data processing, digital communication and test equipment. ECL offers high speed-power products and has the shortest propagation delay of any logic form. As a consequence, many high performance circuits are being designed with internal ECL logic. This internal logic may be required to receive inputs from or provide outputs to, for example, MOS or TTL devices. Or, an ECL chip may receive inputs from or provide output to an $I^2L$ based logic device. Rather than use external translators which waste power and which add delays which work against the inherent short propagation delays of the ECL logic, it is greatly desired that on-chip translation capabilities be provided. The need for translation is due to the unique logic levels for each family. In the ECL logic scheme a voltage more positive than −.8 volt is considered to be a logic "1", while a voltage more negative than −1.6 volts is considered to be a logic "0". In the TTL logic family a voltage greater than +2 volts is considered to be a logic "1" while a voltage less than +.8 volts is considered to be a logic "0". Within integrated injection logic devices, a logic "1" is specified as a voltage greater than $V_{BE}$ and a logic "0" is specified as a voltage less than $V_{SAT}$. For CMOS a digital "1" is $V_{CC}$ and a digital "0" is ground. For any given application there may be a preference for performing logic or storing memory using one particular logic family. As an interface to the logic levels of the environment, on-chip translators may be provided. Reference may be made to Proceedings of the 1st International Conference November 1981 J. C. Conway et al "Computer aided design of gate arrays" which discloses a bipolar gate array Q700 with ECL and TTL inputs/outputs. However, there may be a need to mix several logic families on one chip.

The present invention provides in a semiconductor chip, an integrated circuit device comprising:

a) means for accepting first input signals at the level of a first logic family to produce first internal signals at the level of said first logic family;

b) means for accepting said first input signals at the level of a first logic family to produce second internal signals at the level of a second logic level family;

c) means for accepting second input signals at the level of said second logic family to produce third internal signals at the level of said first logic family;

d) means for accepting said second input signals at the level of said second logic family to produce fourth internal signals at the level of said second logic family;

e) first circuit means, operative at the level of said first logic family for operating upon said first and third internal signals to produce fifth internal signals and sixth internal signals respectively, at the level of said first logic family;

f) second circuit means, operative at the level of said second logic family for operating upon said second and fourth internal signals to produce seventh internal signals and eighth internal signals, respectively at the level of said second logic family;

g) means for providing first output signals at the level of said first logic family in response to said fifth internal signals;

h) means for providing second output signals at the level of said second logic family in response to said sixth internal signals;

i) means for providing third output signals at the level of said first logic family in response to said seventh internal signals; and

j) means for providing fourth output signals at the level of said second logic family in response to said eighth internal signals.

Brief Description of the Drawings

For a more complete understanding of the integrated circuit device of the present invention, reference may be had to the accompanying drawings which are incorporated herein by reference and in which:

Figure 1 is a symbolic diagram of an integrated circuit chip having multiple inputs and multiple outputs;

Figure 2 is a block diagram of the integrated circuit device of the present invention;

Figure 3 is a circuit schematic of a TTL to ECL translation circuit incorporated in one embodiment of the integrated circuit device of Figure 2; and

Figure 4 is a circuit schematic of an ECL to TTL translator incorporated in an embodiment of the integrated circuit device of Figure 2.

Summary of the Invention

An integrated circuit device containing internal logic and/or memory circuitry is provided with means to receive multiple inputs at the voltage levels of different logic families and with means to provide multiple outputs at the voltage levels of different logic families. On-chip input translators receive the inputs at the level of a given logic family and translate to the level required by the internal logic and/or memory circuitry. After performance of logic and/or memory functions, on-chip output translators accept the output of the internal logic and/or memory circuitry and provide external outputs at the voltage levels of the different logic families. No translation is required for inputs or outputs at levels of the logic family of the internal logic and/or memory circuitry. The internal logic and/or memory circuitry is composed of several logic families. On-chip translators may also be added between internal logic and/or memory circuitry of different logic families. Output buffers are preferably included in the output translators.

Description of the Preferred Embodiments

As circuit designers pick and choose from available logic and memory devices, they are increasingly mixing devices of different logic families. Thus, on a printed circuit board an ECL circuit may be placed adjacent a TTL circuit or an I²L circuit. As a consequence, there is required a translation of voltage levels from family to family. External translators such as the Signetics 10124 TTL to ECL translator are available and are used to implement overall circuit function. Since these translators introduce time delays which degrade overall circuit performance, there use is becoming less tolerable as the performance of individual devices, such as high performance ECL, is enhanced. The present arrangement provides translators on-chip to accept inputs at a given logic level, translate them to the logic level required for internal logic or memory operations and then translate the outputs for delivery external to the chip. These on-chip translators are intended to allow multiple inputs of different logic families and provide multiple outputs of different logic families rather than merely make a device look like a device of another logic family as with pseudo-ECL, described above.

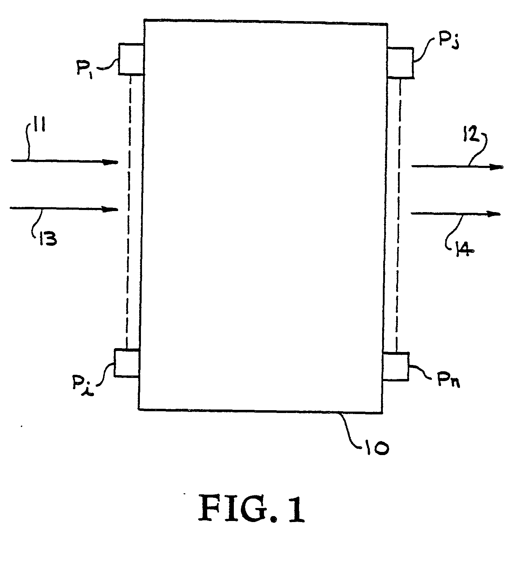

The significance of the on-board translator scheme used in the present invention may be seen with reference to Fig. 1. Integrated circuit device 10 has multiple pins $P_1 \ldots P_i$, $P_j \ldots P_n$. The pins are dedicated for such purposes as inputs, outputs, power supplies and clocking. For a typical integrated circuit device having sixty-four pins, it would be common for five pins to be dedicated to power supplies, twenty-five pins for input lines and thirty-four pins for output lines. With most integrated circuit devices of the prior art, each of the twenty-five input pins would only be able to accept inputs, e.g., inputs on lines 11 or 13, at a specified voltage level associated with the particular logic family of the chip or specified to be accepted by the chip such as with pseudo-ECL. Similarly, output signals, e.g., signals 12 or 14, would have been provided on each of the thirty-four output pins at the voltage level associated with the particular logic family of the chip or specified to be accepted by the chip. With the present invention, whatever the logic family of the internal logic and/or memory units, the inputs may be provided at a voltage level associated with any logic family desired, provided that within the chip there has been provided a translator to translate the voltages as received to the voltage levels of the logic and/or memory circuitry within the chip. Also, the outputs provided on the thirty-four output lines may be provided at voltage levels associated with any logic family desired, provided on-chip translators are available to translate from the level of the internal logic and/or memory circuitry to the output levels. The integrated circuit device of the present invention is highly versatile in that it permits the most suitable logic family to be selected for internal logic and/or memory operations yet allows the device to be mixed and matched with devices based on various logic families.

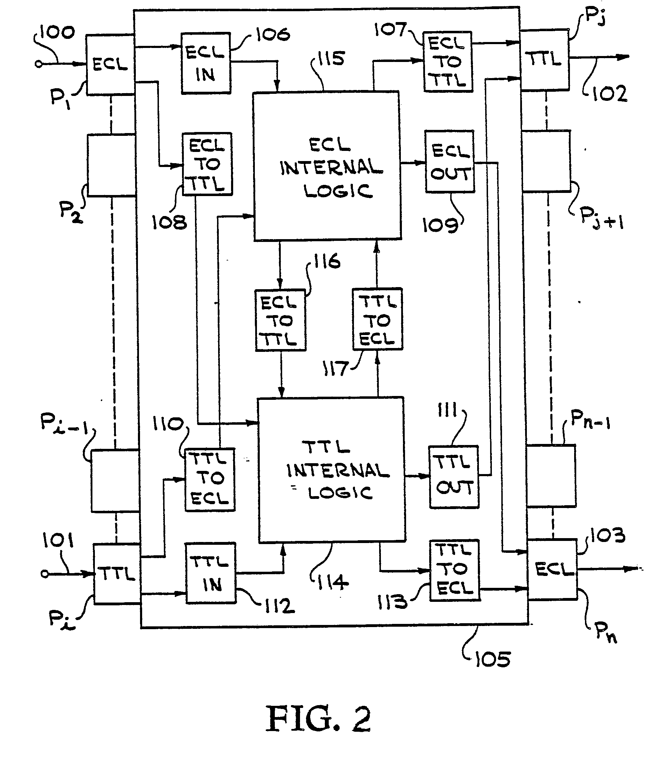

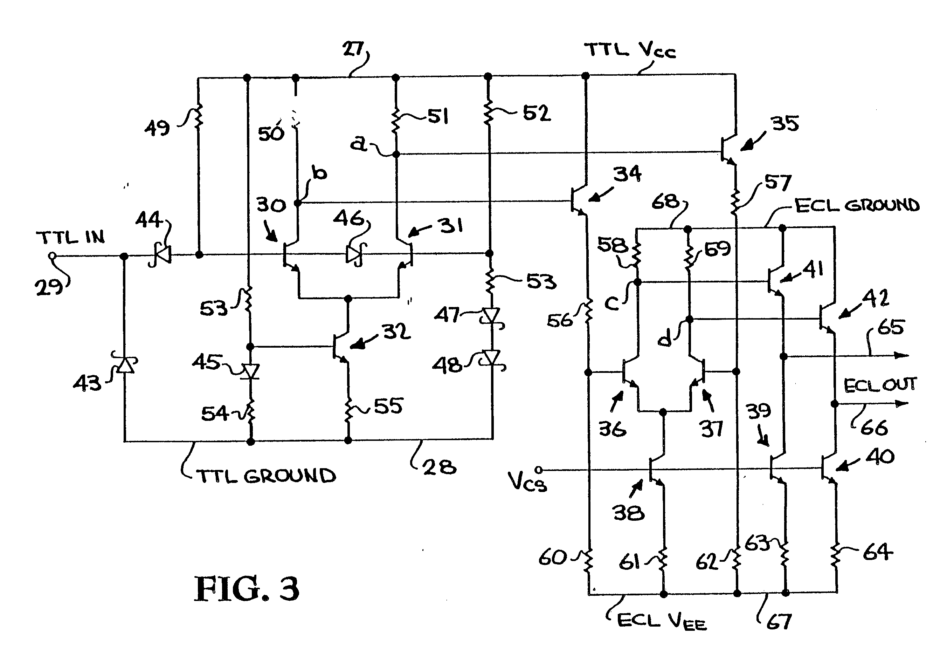

We will describe a TTL to ECL translator for use in a semiconductor chip of the invention shown in Fig. 2. Inside the chip the TTL level voltages are translated in TTL to ECL translators 110, 113, a preferred embodiment of which is described subsequently and shown in Fig. 3.

The shifting of a TTL level to an ECL level is accomplished by the circuit shown in Fig. 3. This is a preferred circuit embodiment; many circuit schemes could accomplish similar results. The differential drive within the circuit of Fig. 3 allows a small voltage to change the logic swing on the output, i.e., the circuit will respond quickly to changes in logic levels since only about .4 volt is required to produce a swing. Since logical swings in logic circuits occur at about 1 volt per nanosecond, the lesser the voltage to produce a recognizable change in logic state, the faster the swing. This explains the low propagation delay of ECL logic since a voltage swing of only .2 to .4 volt reaches the threshold of a change in logic state whereas with TTL a voltage swing of 1.2 to 1.5 volts is required. With the translator of Fig. 3 the fast response preserves the performance of the overall integrated circuit device, i.e. the performance of ECL internal logic is not degraded. The operation of the circuit of Fig. 3 will be described for both a TTL input signifying a logic 1 and a TTL input signifying a logic 0.

TTL Input of 3 volts — Logic 1

With a TTL input of 3 volts impressed on terminal 29 the Schottky diode 44 is reversed biased and shut off. Current then flows through resistor 49 into the base of transistor 30 which is thereby turned on. The base of transistor 31 is at a fixed potential due to the voltage drops between $V_{CC}$ line 27 and TTL ground line 28 across resistors 52 and 53 and across Schottky diodes 47 and 48. Thus, since the emitters of transistors 30 and 31 are connected, the turning on of transistor 30 will provide a sharp turnoff of transistor 31. The current through transistor 30 will be supplied by constant current source 32 which supplies a current determined by the values of resistors 55 and 54, the characteristics of diode 45 and the value of resistor 53. Since transistor 30 is turned on and transistor 31 is turned off, all current from transistor 32 flows through transistor 30. The current through transistor 30 also passes through resistor 50 producing a potential on node a between TTL $V_{CC}$ and TTL ground. Since transistor 31 is off, there is no voltage drop across resistor 51 so that node a is at the potential of TTL $V_{CC}$. Consequently, the voltage on the base of transistor 35 will be greater than the voltage on the base of transistor 34. Thus, the current through transistor 35, resistor 57 and resistor 62 will be initially greater than the current through transistor 34, resistor 56 and resistor 60. In the most preferred embodiment, the values of resistors 56 and 57 are equal and the values of resistors 60 and 62 are equal to thereby provide potentials on the bases of transistors 36 and 37 which track the current flows through transistors 34 and 36. Consequently, the voltage on the base of transistor 37 is at a higher potential than the voltage on the base of transistor 36. In well-known circuit fashion, since the emitters of transistors 36 and 37 are tied together, transistor 37 turns full on and transistor 36 turns off. The current through transistor 37 is supplied through constant current source 38 and resistor 61. Since transistor 36 is off and transistor 37 is on, there is no current through resistor 58 but there is a current through resistor 59. Thus, node a is at ECL ground level potential while node d is at a negative level between ECL ground and ECL reference voltage $V_{EE}$ (−5.2 volts). Consequently, the base of transistor 42 is at a more negative potential than the base of transistor 41. Thus, while currents are flowing through both the parallel legs comprising transistor 41, transistor 39 and resistor 63 and comprising transistor 42, transistor 40 and resistor 64, the current through transistor 41 will be greater than the current through transistor 42. Thus, the potential on the emitter of transistor 41 will be higher than the potential on the emitter of transistor 42 so that the non-inverting output line 65 will have a higher potential than the inverting output line 66. Together, ECL output line 65 and 66 provide the typical complementary logic levels associated with ECL logic. The function of constant current sources consisting of transistor 39 and resistor 63 and of transistor 40 and resistor 64 are to provide a constant base-to-emitter voltage across output transistors 41 and 42. The constant current sources 39, 63 and 40, 64 are controlled by stable bandgap reference voltage $V_{CS}$ typically available on ECL chips. See, e.g., A. H. Seidman, *Integrated Circuits Applications Handbook*, pp. 498—499 (1983).

TTL Input of .3 Volts — Logic 0

When a voltage of less than 3 volts is impressed on TTL input terminal 29, Schottky diode 44 will experience a voltage drop of about .4 volts. Since the base of transistor 31 is at a fixed potential, as described previously, transistor 31 will turn on hard and transistor 30 will turn off due to the low potential impressed upon its base. There will now be experienced a current flow through resistor 51 with no current being passed through resistor 50. Thus, node b will be at the level of TTL $V_{CC}$ whereas node a will be at a lower level. Thus, the voltage on the base of transistor 35 will be lower than the voltage on the base of transistor 34. The lower current through the transistor 34 will produce a higher voltage on the base of transistor 36 than is produced by the current through transistor 35 on the base of transistor 37. Transistor 36 will become conductive thereby turning transistor 37 off due to the coupled emitters. The current through constant current source 38 and resistor 61 will flow through transistor 36 and resistor 58 between ECL $V_{EE}$ line 67 and ECL ground line 68. Consequently, the voltage on node c will be at a more negative potential than the potential on node d which is at the ECL ground level. Thus, the voltage on the base of transistor 42 is greater than the voltage on the base of transistor 41. Consequently, the current through transistor 42 is greater than the current through transistor 41 and the level of inverting ECL output line 66 is greater than the level of non-inverting ECL output line 65. The magnitude of the voltage levels is in accordance with TTL and ECL conventions, described above, and is determined by selecting values for resistors and specifying characteristics of transistors and diodes.

The description of the preceding paragraphs has been of a TTL to ECL logic translator suitable for use in blocks 110, 113 and 117 of Fig. 2. The outputs available on lines 65 and 66 are non-inverting and inverting logic levels, respectively, and will be at a level suitable for use with ECL internal logic circuit 19.

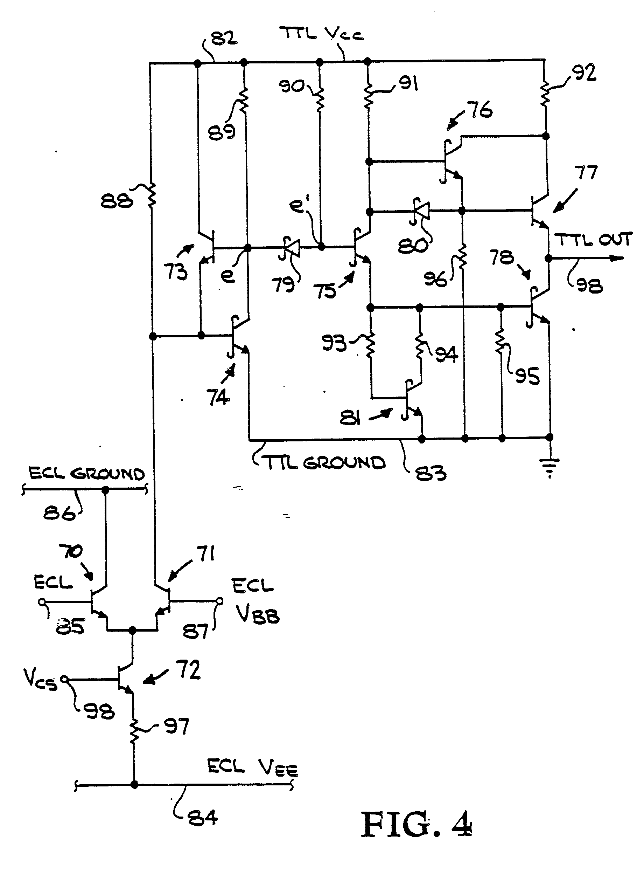

An ECL to TTL translator is shown in Fig. 4. This translator is suitable for use in blocks 107, 108 and 116 of Fig. 2. Simpler circuits may be designed, but the differential circuit of Fig. 4 will not degrade the overall performance of the integrated circuit device since it has a fast response time. As far as an end user is concerned, the performance of integrated circuit device will meet ECL standards and yet may be mixed and matched with devices designed with different logic families. The operation of the translator of Fig. 4 is described below in terms of ECL inputs signifying a logic 1 and signifying a logic 0.

ECL Input of −.8 Volts — Logic 1

Since complementary levels are typically available on ECL gate circuits, the ECL to TTL translator circuit of Fig. 4 may be operated in several ways. One method of operation would be to apply the non-inverting ECL level on input 85 and the inverting level on input terminal 87. This would produce a clearcut swing on the differential pair 70, 71 as the logic levels changed. Alternatively, one or the other of the complementary logic levels may be supplied on input terminal 85 to transistor 70 with the ECL standard reference voltage $V_{BB}$ being supplied on input terminal 87 on the base of transistor 71. This will also produce a swing on the differential pair 70, 71 as the ECL logic swings. The following discussion is of the operation when a non-inverting input is supplied on the terminal 85. The terminal 87 on the base of transistor 71 is held at the ECL $V_{BB}$ reference, −1.2 volts. See, e.g., W. C. Seelbach, "Emitter-Coupled Logic", in *Integrated Circuits Applications Handbook*, p. 63 (1983). Thus, with a voltage of −.8 volts impressed on terminal 85 the voltage on the base of transistor 70 will be greater than the voltage on the base of transistor 71. Transistor 70 will turn on and transistor 71 will turn off since the emitters of the two transistors are interconnected. The constant current through transistor 72 and resistor 97 will thus pass through transistor 70 to the ECL ground line 86. The value of the current will be controlled by the bandgap reference voltage $V_{CS}$ impressed on the base terminal 98 of transistor 72. Since transistor 71 is turned off, there is no contribution through transistor 71 to the current in transistor 88. The base of Schottky transistor 74 is at a potential of approximately .7 volts. Thus, Schottky transistor 74 is turned on. The current through transistor 74 and resistor 89 between TTL $V_{CC}$ line 82 and TTL ground line 83 will lower the potential at node e on the base of transistor 73. The potential which resides on the base of transistor 73 will be .3 volts, the saturation voltage $V_{SAT}$. Consequently, the potential at e′ on the base of Schottky transistor 75 is $V_{SAT}$ plus the diode drop across Schottky diode 79. Thus, Schottky transistors 75 and 78 are both off because the voltage on the base of transistor 75 is not high enough to turn it on. Since there is no current through Schottky transistor 75, the base of Schottky transistor 76 goes to the level of TTL $V_{CC}$ so that transistor 76 turns on. The current flowing through resistor 92, Schottky transistor 76 and resistor 96 produces a potential on the base of transistor 77 which turns it on. Thus, the emitter output of transistor 77 is at two base-to-emitter voltages less than $V_{CC}$. This will be at least 3 volts so that a logic 1 is indicated on TTL output line 98.

ECL Input of −1.6 Volts — Logic 0

When a voltage of −1.6 volts is impressed upon the terminal 85 on the base of transistor 70, it will occur that the fixed voltage of −1.2 volts on the terminal 87 will be greater. Consequently, transistor 71 turns on and transistor 70 turns off. Current now flows through resistor 97, transistor 72, transistor 71 and resistor 88 between ECL $V_{EE}$ line 84 and TTL $V_{CC}$ line 82. The values of resistors 97 and 88 are selected such that when transistor 71 is turned on, sufficient current flows so that the voltage on the base of transistor 74 would be below the TTL ground level if transistor 73 were not in the circuit. Transistor 73 serves to prevent the voltage on the base of transistor 74 from going to the ground level. When the voltage on the base of transistor 74 approaches ground, the base-to-emitter voltage across Schottky transistor 74 is very small and transistor 74 is off. Consequently, there is no voltage drop across resistors 89 and 90 and the potentials at nodes e and e′ rise. Since Schottky transistor 74 is turned off, the voltage on the base of Schottky transistor 75 rises to two base-to-emitter voltage drops (the drops across Schottky transistors 75 and 78). As a consequence, Schottky transistors 75 and 78 are turned on. Since Schottky transistor 78 is conducting in a saturation mode, the TTL output line 98 is pulled down low. Its voltage will be less than .8 volt and will signify a logic 0.

The internal translator scheme, in accordance with the present invention, is incorporated in embodiments with internal logic of several logic families or with mixed logic and memory circuits of several families. For example, it may be desirable to have the logic configured in one logic family such as ECL and to have the memory configured in another logic family such as TTL. It is possible to mix both bipolar logic families such as TTL, ECL or $I^2L$ with MOS families such as CMOS and MOS. By adding a number of process steps both bipolar and MOS devices can be produced on the same chip. A semi-conductor chip of the present invention incorporating mixed logic families on-chip is shown in Fig. 2. ECL internal logic 115 and TTL internal logic 114 are fabricated on the same integrated circuit device 105. Inputs at the ECL logic level are provided on line 100 to pin $P_1$. The ECL logic levels are provided directly through the ECL input port 106 directly to ECL internal logic 115. The ECL level logic is translated in ECL to TTL translator 108 and supplied to TTL internal logic 114. The TTL input logic is supplied on line 101 to pin $P_1$. The TTL inputs are supplied directly through TTL input port 112 to TTL internal logic 114. The TTL level logic is translated in TTL to ECL translator 110 and supplied to ECL internal logic 115. The ECL to TTL translator 108 may be fabricated in accordance with the embodiment of Fig. 3 and the TTL to ECL translator 110 may be fabricated in accordance with the circuit of Fig. 4. The ECL output from the ECL internal logic 115 is supplied directly through ECL output port 109 to ECL output pin $P_n$ and thence to ECL output line 103.

ECL output port 109 will include a buffer to drive the output impedance of at least 50 ohms on ECL output line 103. The ECL output from ECL internal logic 115 is also supplied to ECL to TTL translator 107 and thence to TTL output pin $P_j$ and TTL output line 102. The output from TTL internal logic 114 is supplied directly through TTL output port 111 to TTL output pin $P_j$ and thence to TTL output line 102. Finally, the TTL output from TTL internal logic 114 is supplied to TTL to ECL translator 113 and thence to ECL output pin $P_n$ and ECL output line 103. Since the input ports 106 and 112, the output ports 109 and 111 and the translators 107, 108, 110 and 113 together add only about 10% to the die size, it is also feasible to add crosstalk translators so that the ECL internal logic 115 and the TTL internal logic 114 can communicate during processing. Thus, TTL to ECL translator 117 is provided to send TTL outputs to ECL internal logic 115 and ECL to TTL translator 116 is provided to communicate ECL outputs to TTL internal logic 114.

The mixing of logic families as shown in Fig. 2 is possible for any combination of logic families providing sufficient translators are provided on-chip. Tradeoffs in processing must be made between the optimization of one logic family and another in accordance with known processing techniques. Thus, for example, $I^2L$ may be mixed with ECL, MOS with TTL, ECL with CMOS, etc.

The foregoing description of a preferred embodiment of the invention has been presented for purposes of illustration and description. It is not intended to be exhaustive or to limit the invention to the precise form disclosed, and obviously many modifications and variations are possible in light of the above teaching. The embodiment was chosen and described in order to best explain the principles of the invention and its practical application to thereby enable others skilled in the art to best utilize the invention in various embodiments and with various modifications as are suited to the particular use contemplated. It is intended that the scope of the invention be defined by the claims appended hereto.

## Claims

1. In a semiconductor chip, an integrated circuit device comprising:

a) means (112) for accepting first input signals at the level of a first logic family to produce first internal signals at the level of said first logic family;

b) means (110) for accepting said first input signals at the level of a first logic family to produce second internal signals at the level of a second logic level family;

c) means (108) for accepting second input signals at the level of said second logic family to produce third internal signals at the level of said first logic family;

d) means (106) for accepting said second input signals at the level of said second logic family to produce fourth internal signals at the level of said second logic family;

e) first circuit means (114), operative at the level of said first logic family for operating upon said first and third internal signals to produce fifth internal signals and sixth internal signals respectively, at the level of said first logic family;

f) second circuit means (115), operative at the level of said second logic family for operating upon said second and fourth internal signals to produce seventh internal signals and eighth internal signals, respectively at the level of said second logic family;

g) means (111) for providing first output signals at the level of said first logic family in response to said fifth internal signals;

h) means (113) for providing second output signals at the level of said second logic family in response to said sixth internal signals;

i) means (107) for providing third output signals at the level of said first logic family in response to said seventh internal signals; and

j) means (109) for providing fourth output signals at the level of said second logic family in response to said eighth internal signals.

2. An integrated circuit device as claimed in claim 1 characterised in that said means (110) for accepting said first input signals at the level of a first logic family to produce second internal signals comprises means for translating the level of said first input signals from the level of said first logic family to the level of said second logic family.

3. An integrated circuit device as claimed in claim 1 or 2 characterised in that said means (112) for accepting the first input signals at the level of a first logic family to produce said first internal signals comprises means (112) for directly coupling said first input signals to said first circuit means.

4. An integrated circuit device according to claims 1 or 2 characterised in that said means (112) for accepting the first input signals at the level of a first logic family to produce said first internal signals comprises buffer means.

5. An integrated circuit device as claimed in any of claims 1 to 4 characterised in that said means (108) for accepting second input signals at the level of said second logic family to produce third internal signals comprises means for translating the level of said second input signals from the level of said second logic family to the level of said first logic family.

6. An integrated circuit device as claimed in any of claims 1 to 5 characterised in that said means (106) for accepting said second input signals at the level of said second logic family to produce fourth internal signals comprises means (106) for directly coupling said second input signals to said second circuit means.

7. An integrated circuit device according to any of claims 1 to 5 characterised in that the means (106) for accepting the second input signals at the level of said second logic family to produce fourth internal signals comprises buffer means.

8. An integrated circuit device as claimed in any of claims 1 to 7 characterised in that said means (113) for providing second output signals at the level of said second logic family in response to said sixth internal signals comprises means for translating said sixth signals from the level of said first logic family to the level of said second logic family.

9. An integrated circuit device as claimed in any of claims 1 to 8 characterised in that said means (111) for providing first output signals at the level of said first logic family in response to said fifth internal signals comprises buffer means for receiving said fifth internal signals from said first circuit means and providing an external output.

10. An integrated circuit device as claimed in any of claims 1 to 9 characterised in that said means (107) for providing third output signals at the level of the first logic family in response to said seventh internal signals comprises means for translating said seventh internal signals from the level of said second logic family to the level of said first logic family.

11. An integrated circuit device as claimed in any of claims 1 to 10 characterised in that said means (109) for providing fourth output signals at the level of said second logic family in response to said eighth internal signals includes buffer means for receiving said eighth internal signals from said second circuit means and providing an external output.

12. An integrated circuit device as claimed in any of claims 1 to 11 characterised in that said first logic family is transistor-transistor logic and said second logic family is emitter coupled logic.

13. An integrated circuit device as claimed in any of claims 1 to 12 characterised in that each said circuit means (114, 115) comprises a logic circuit means.

14. An integrated circuit device as claimed in any of claims 1 to 12 characterised in that each circuit means (114, 115) comprises memory circuit means.

15. An integrated circuit device as claimed in any of claims 1 to 12 characterised in that each circuit means (114, 115) comprises a logic means and memory means.

16. An integrated circuit device as claimed in any of claims 1 to 15 characterised in that said means (113) for providing second output signals at the level of said second logic family in response to said sixth internal signals and/or said means (110) for accepting said first input signals at the level of a first logic family to produce second internal signals at the level of a second logic level family comprise a TTL to ECL translator comprising:

a constant current source transistor (32) having its emitter connected to TTL ground (28);

a first pair of bipolar transistors (30, 31) having their emitters connected in common to the collector of said constant current source transistor (32), the base of one transistor (31) having a fixed reference voltage applied thereto and the base of the other transistor (30) being coupled to the TTL input line (29) so that said pair of bipolar transistors (30, 31) conduct differentially as the TTL input level is above or below said fixed reference voltage;

a second pair of bipolar transistors (34, 35) having their bases connected to the collectors of respective ones of said first pair of bipolar transistors (30, 31), having their collectors connected to TTL $V_{cc}$ and having their emitters connected through respective resistor strings (56, 60; 57, 62) to the ECL $V_{EE}$ line (67);

a second constant current source transistor (38) having its emitter connected to said ECL $V_{EE}$ line (67);

a third pair of bipolar transistors (37, 37) having their emitters connected in common to the collector of said second current source transistor (38) and having their bases connected respectively to the emitters of respective ones of said second pair of bipolar transistors (34, 35); and

a pair of output transistors (41, 42) having their bases connected to respective ones of the collectors of said third pair of bipolar transistors (36, 37), their collectors connected in common to ECL ground (68) and their emitters connected through current stabilising means (39, 40) to ECL $V_{EE}$ (67), the emitters of said pair of output transistors (41, 42) serving as inverting and non-inverting ECL outputs.

17. An integrated circuit device as claimed in any of claims 1 to 16 characterised in that said means (108) for accepting second input signals at the level of said second logic family to produce third internal signals at the level of said first logic family and/or said means (107) for providing third output signals at the level of the first logic family in response to said seventh internal signals comprise an ECL to TTL translator, including

a constant current source transistor (72) having its emitter connected to the ECL $V_{EE}$ reference level (84) and its base connected to a band gap reference voltage $V_{CS}$ (98);

a pair of bipolar transistors (70, 71) having their emitters connected in common to the collector of said constant current source transistor (72) and having their collectors connected respectively to ECL ground (86) and to a differential drive circuit, said differential drive circuit comprising:

a pullup output transistor (77) having its emitter connected to the TTL output line (98) and its collector connected to TTL $V_{CC}$ (82);

a pulldown output transistor (78) having its collector connected to the TTL output line (98) and its emitter connected to TTL ground (83);

a first base drive transistor (76) having its emitter connected to the base of said pullup output transistor (77) and having its collector connected to the collector of said pullup output transistor (77);

a second base drive transistor (75) having its emitter connected to the base of said pulldown output transistor (78) and having its collector connected to TTL $V_{CC}$ (82) through a resistor (91) and to the base of the pullup output transistor (76) through a diode (80); and

means in response to current from said constant current source transistor (72) conducted through one of said pair of bipolar transistors (70, 71) connected to said differential drive circuit to turn said first base drive transistor (76) on or off and thereby turn said second base drive transistor (75) off or on to either pullup or pulldown said TTL output level in accordance with an ECL input level applied to the base of at least one of said pair of bipolar transistors (70, 71).

**Patentansprüche**

1. Intergrierte Schaltungsvorrichtung in einem Halbleiterchip, mit

a) einem Mittel (112) zum Annehmen erster Eingangssignale mit dem Pegel einer ersten Logikfamilie, um erste interne Signale mit dem Pegel der ersten Logikfamilie zu erzeugen;

b) einem Mittel (110) zum Annehmen erster Eingangssignale mit dem Pegel einer ersten Logikfamilie, um zweite interne Signale mit dem Pegel einer zweiten Logikpegelfamilie zu erzeugen;

c) einem Mittel (108) zum Annehmen zweiter Eingangssignale mit dem Pegel der zweiten Logikfamilie, um dritte interne Signale mit dem Pegel der ersten Logikfamilie zu erzeugen;

d) einem Mittel (106) zum Annehmen der zweiten Eingangssignale mit dem Pegel der zweiten Logikfamilie, um vierte interne Signale mit dem Pegel der zweiten Logikfamilie zu erzeugen;

e) ersten auf dem Pegel der ersten Logikfamilie betreibbaren Schaltungsmitteln (114) zum Betrieb auf das erste und das dritte interne Signal hin, um jeweils fünfte interne Signale und sechste interne Signale mit dem Pegel der ersten Logikfamilie zu erzeugen;

f) zweiten auf dem Pegel der zweiten Logikfamilie betreibbaren Schaltungsmitteln (115) zum Betrieb auf das zweite und das vierte interne Signal hin, um jeweils siebte interne Signale und achte interne Signale mit dem Pegel der zweiten Logikfamilie zu erzeugen;

g) einem Mittel (111) zum Liefern erster Ausgangssignale mit dem Pegel der ersten Logikfamilie in Beantwortung der fünften internen Signale;

h) einem Mittel (113) zum Liefern zweiter Ausgangssignale mit dem Pegel der zweiten Logikfamilie in Beantwortung der sechsten internen Signale;

i) einem Mittel (107) zum Liefern dritter Ausgangssignale mit dem Pegel der ersten Logikfamilie in Beantwortung der siebten internen Signale;

j) einem Mittel (109) zum Liefern vierter Ausgangssignale mit dem Pegel der zweiten Logikfamilie in Beantwortung der achten internen Signale.

2. Integrierte Schaltungsvorrichtung nach Anspruch 1, dadurch gekennzeichnet, daß das Mittel (110) zum Annehmen der ersten Eingangssignale mit dem Pegel einer ersten Logikfamilie zum Erzeugen zweiter interner Signale, ein Mittel zum Umsetzen des Pegels der ersten Eingangssignale von dem Pegel der ersten Logikfamilie auf den Pegel der zweiten Logikfamilie umfaßt.

3. Integrierte Schaltungsvorrichtung nach Anspruch 1 oder 2, dadurch gekennzeichnet, daß das Mittel (112) zum Annehmen der ersten Eingangssignale mit dem Pegel einer ersten Logikfamilie zum Ezeugen erster interner Signale, ein Mittel (112) zum direkten Koppeln der ersten Eingangssignale mit dem ersten Schaltungsmittel umfaßt.

4. Integrierte Schaltungsvorrichtung nach Anspruch 1 oder 2, dadurch gekennzeichnet, daß das Mittel (112) zum Annehmen der ersten Eingangssignale mit dem Pegel einer erster Logikfamilie zum Erzeugen erster interner Signale, ein Puffermittel umfaßt.

5. Integrierte Schaltungsvorrichtung nach einem der Ansprüche 1 bis 4, dadurch gekennzeichnet, daß das Mittel (108) zum Annehmen der zweiten Eingangssignale mit dem Pegel einer zweiten Logikfamilie zum Erzeugen dritter interner Signale, ein Mittel zum Umsetzen des Pegels der zweiten Eingangssignale von dem Pegel der zweiten Logikfamilie auf den Pegel der ersten Logikfamilie umfaßt.

6. Integrierte Schaltungsvorrichtung nach einem der Ansprüche 1 bis 5, dadurch gekennzeichnet, daß das Mittel (106) zum Annehmen der zweiten Eingangssignale mit dem Pegel der zweiten Logikfamilie zum Erzeugen vierter interner Signale, ein Mittel (106) zum direkten Koppeln der zweiten Eingangssignale mit dem zweiten Schaltungsmittel umfaßt.

7. Integrierte Schaltungsvorrichtung nach einem der Ansprüche 1 bis 5, dadurch gekennzeichnet, daß das Mittel (106) zum Annehmen der zweiten Eingangssignale mit dem Pegel einer zweiten Logikfamilie, zum Erzeugen vierter interner Signale, ein Puffermittel umfaßt.

8. Integrierte Schaltungsvorrichtung nach einem der Ansprüche 1 bis 7, dadurch gekennzeichnet, daß das Mittel (113) zum Liefern zweiter Ausgangssignale mit dem Pegel der zweiten Logikfamilie auß die sechsten internen Signale hin ein Mittel zum Umsetzen der sechsten Signale von dem Pegel der ersten Logikfamilie auf den Pegel der zweiten Logikfamilie umfaßt.

9. Integrierte Schaltungsvorrichtung nach einem der Ansprüche 1 bis 9, dadurch gekennzeichnet, daß das Mittel (111) zum Liefern erster Ausgangssignale mit dem Pegel der ersten Logikfamilie auf die fünften internen Signale hin ein Puffermittel zum Empfang der fünften internen Signale von dem ersten Schaltungsmittel und zum Liefern eines externen Ausgangs umfaßt.

10. Integrierte Schaltungsvorrichtung nach einem der Ansprüche 1 bis 9, dadurch gekennzeichnet, daß das Mittel (107) zum Liefern dritter Ausgangssignale mit dem Pegel der ersten Logikfamilie auf die siebten internen Signale hin ein Mittel zum Umsetzen der siebten internen Signale von dem Pegel der zweiten Logikfamilie auf den Pegel der ersten Logikfamilie umfaßt.

11. Integrierte Schaltungsvorrichtung nach einem der Ansprüche 1 bis 10, dadurch gekennzeichnet, daß das Mittel (109) zum Liefern vierter Ausgangssignale mit dem Pegel der zweiten Logikfamilie auf die achten internen Signale hin ein Puffermittel zum Empfang der achten internen Signale von dem zweiten Schaltungsmittel und zum Liefern eines externen Ausgangs umfaßt.

12. Integrierte Schaltungsvorrichtung nach einem der Ansprüche 1 bis 11, dadurch gekennzeichnet, daß die erste Logikfamilie eine Transistor-Transistor-Logik und die zweite Logikfamilie eine emittergekoppelte Logik ist.

13. Integrierte Schaltungsvorrichtung nach einem der Ansprüche 1 bis 12, dadurch gekennzeichnet, daß jedes der Schaltungsmittel (114, 115) ein Logikschaltungsmittel aufweist.

14. Integrierte Schaltungsvorrichtung nach einem der Ansprüche 1 bis 12, dadurch gekennzeichnet, daß jedes der Schaltungsmittel (114, 115) ein Speicherschaltungsmittel aufweist.

15. Integrierte Schaltungsvorrichtung nach einem der Ansprüche 1 bis 12, dadurch gekennzeichnet, daß jedes der Schaltungsmittel (114, 115) ein Logik- und ein Speichermittel aufweist.

16. Integrierte Schaltungsvorrichtung nach einem der Ansprüche 1 bis 15, dadurch gekennzeichnet, daß das Mittel (113) zum Liefern zweiter Ausgangssignale mit dem Pegel der zweiten Logikfamilie auf die sechsten internen Signale hin und/oder das Mittel (110) zum Annehmen der ersten Eingangssignale mit dem Pegel einer ersten Logikfamilie zum Erzeugen zweiter interner Signale mit dem Pegel einer zweiten Logikpiegelfamilie, einen TTL-zu-ECL-Umsetzer aufweisen, mit

einem Konstantstromquellentransistor (32), dessen Emitter an TTL-Masse (28) angeschlossen ist;

einem ersten Paar Bipolartransistoren (30, 31), deren Emitter gemeinsam an dem Kollektor des Konstantstromquellentransistors (32) angeschlossen sind, wobei an der Basis eines Transistors (31) eine feste Referenzspannung anliegt und die Basis des anderen Transistors (30) mit der TTL-Eingangsleitung (29) gekoppelt ist, so daß das Paar Bipolartransistoren (30, 31) unterschiedlich leitet, wenn der TTL-Eingangspegel über oder unter der festen Referenzspannung liegt;

einem zweiten Paar Bipolartransistoren (34, 35), deren Basen mit jeweils einem der Kollektoren des ersten Paares Bipolartransistoren (30, 31) verbunden sind und deren Kollektoren mit TTL-$V_{CC}$ und deren Emitter über jeweilige Widerstandsketten (56, 60; 57, 62) mit der ECL-$V_{EE}$-Leitung (67) verbunden sind;

einem zweiten Konstantstromquellentransistor (38), dessen Emitter mit der ECL-$V_{EE}$-Leitung (67) verbunden ist;

einem dritten Paar Bipolartransistoren (36, 37), deren Emitter gemeinsam mit dem Kollektor des zweiten Konstantstromquellentransistors (38) und deren Basen jeweils mit einem der Emitter der jeweiligen Transistoren des zweiten Paares bipolarer Transistoren (34, 35) verbunden sind; und

einem Paar Ausgangstransistoren (41, 42), deren Basen mit jeweils einem der Kollektoren des dritten Paares Bipolartransistoren (36, 37) und deren Kollektoren gemeinsam mit ECL-Masse (68) und deren Emitter über Stromstabilisierungsmittel (39, 40) mit ECL-$V_{EE}$ (67) verbunden sind, wobei die Emitter des Ausgangstransistorpaares (41, 42) als invertierende und nicht-invertierende ECL-Ausgänge dienen.

17. Integrierte Schaltungsvorrichtung nach einem der Ansprüche 1 bis 16, dadurch gekennzeichnet, daß das Mittel (108) zum Annehmen der zweiten Eingangssignale mit dem Pegel der zweiten Logikfamilie zum Erzeugen dritter interner Signale und/oder das Mittel (107) zum Liefern dritter Ausgangssignale mit dem Pegel der ersten Logikfamilie auf die siebten internen Signale hin, einen ECL-zu-TTL-Umsetzer aufweisen, mit

einem Konstantstromquellentransistor (72), dessen Emitter mit dem ECL-$V_{EE}$-Referenzpegel (84) und dessen Basis mit einer Bandabstand-Referenzspannung $V_{CS}$ (98) verbunden ist;

einem Paar Bipolartransistoren (70, 71), deren Emitter gemeinsam mit dem Kollektor des Konstantstromquellentransistors (72) und deren Kollektoren mit ECL-Masse beziehungsweise mit einer Differential-Ansteuerschaltung verbunden sind, wobei die Differential-Ansteuerschaltung umfaßt;

einen Pullup-Ausgangstransistor (77), dessen Emitter mit der TTL-Ausgangsleitung (98) und dessen Kollektor mit TTL-$V_{cc}$ (82) verbunden ist;

einen Pulldown-Ausgangstransistor (78), dessen Kollektor mit der TTL-Ausgangsleitung (98) und dessen Emitter mit TTL-Masse (83) verbunden ist;

einen ersten Basis-Ansteuertransistor (76), dessen Emitter mit der Basis des Pullup-Ausgangstransistors (77) und dessen Kollektor mit dem Kollektor des Pullup-Ausgangstransistors (77) verbunden ist;

einen zweiten Basis-Ansteuertransistor (75), dessen Emitter mit der Basis des Pulldown-Ausgangstransistors (78) und dessen Kollektor über einen Widerstand (91) mit TTL-$V_{cc}$ (82) und über eine Diode (80) mit der Basis des Pullup-Ausgangstransistors (77) verbunden ist; und

ein Mittel zum Antworten auf Strom von dem Konstantstromquellentransistor (72), der durch einen der beiden Bipolartransistoren (70, 71) geleitet wird, der mit der Differential-Ansteuerschaltung verbunden ist, um den ersten Basis-Ansteuertransistor (76) ein- oder auszuschalten und dadurch den zweiten Basis-Ansteuertransistor (75) aus oder einzuschalten, um den TTL-Ausgangspegel in Übereinstimmung mit einem der Basis wenigstens einem der beiden Bipolartransistoren (70, 71) zugeführten ECL-Eingangspegels entweder einem Pull-up- oder einem Pull-down-Vorgang zu unterziehen.

**Revendications**

1. Dans une puce à semi-conducteurs, un dispositif à circuits intégrés comprenant:

(a) des moyens (112) pour accepter des premiers signaux d'entrée au niveau d'une première famille logique pour produire des premiers signaux internes au niveau de ladite première famille logique;

(b) des moyens (110) pour accepter lesdits premiers signaux d'entrée au niveau d'une première famille logique pour produire des deuxièmes signaux internes au niveau d'une seconde famille de niveaux logiques;

(c) des moyens (108) pour accepter des deuxièmes signaux d'entrée au niveau de ladite deuxième famille logique pour produire des troisièmes signaux internes au niveau de ladite première famille logique;

(d) des moyens (106) pour accepter lesdits deuxièmes signaux d'entrée au niveau de ladite deuxième famille logique pour produire des quatrièmes signaux internes au niveau de ladite deuxième famille logique;

(e) des premiers moyens de circuit (114), fonctionnant au niveau de ladite première famille logique et opérant sur lesdits premiers et troisièmes signaux internes pour produire des cinquièmes signaux internes et des sixièmes signaux internes respectivement, au niveau de ladite première famille logique;

(f) des deuxièmes moyens de circuit (115), fonctionnant au niveau de ladite deuxième famille logique et opérant sur lesdits deuxièmes et quatrièmes signaux internes pour produire des septièmes signaux internes et huitièmes signaux internes, respectivement au niveau de ladite deuxième famille logique;

(g) des moyens (111) pour fournir des premiers signaux de sortie au niveau de ladite première famille logique en réponse auxdits cinquièmes signaux internes;

(h) des moyens (113) pour fournir des deuxièmes signaux de sortie au niveau de ladite deuxième famille logique en réponse auxdits sixièmes signaux internes;

(i) des moyens (107) pour fournir des troisièmes signaux de sortie au niveau de ladite première famille logique en réponse auxdits septièmes signaux internes; et

(j) des moyens (109) pour fournir des quatrièmes signaux de sortie au niveau de ladite deuxième famille logique en réponse auxdits huitièmes signaux internes.

2. Un dispositif à circuits intégrés selon la revendication 1, caractérisé en ce que lesdits moyens (110) pour accepter lesdits premiers signaux d'entrée au niveau d'une première famille logique, pour produire des deuxièmes signaux internes, comporte des moyens pour traduire le niveau desdits premiers signaux d'entrée du niveau de ladite première famille logique au niveau de ladite deuxième famille logique.

3. Un dispositif à circuits intégrés selon la revendication 1 ou 2, caractérisé en ce que lesdits moyens (112) pour accepter les premiers signaux d'entrée au niveau d'une première famille logique, pour produire lesdits premiers signaux internes, comporte des moyens (112) pour coupler directement lesdits premiers signaux d'entrée auxdits premiers moyens de circuit.

4. Un dispositif à circuits intégrés selon la revendication 1 ou 2, caractérisé en ce que lesdits moyens (112) pour accepter les premiers signaux d'entrée au niveau d'une première famille logique, pour produire lesdits premiers signaux internes, comporte des moyens de circuit tampon.

5. Un dispositif à circuits intégrés selon l'une quelconque des revendications 1 à 4, caractérisé en ce que lesdits moyens (108) pour accepter des deuxièmes signaux d'entrée au niveau de ladite deuxième famille logique pour produire des troisièmes signaux internes, comporte des moyens pour traduire le niveau desdits deuxièmes signaux d'entrée du niveau de ladite deuxième famille logique au niveau de ladite première famille logique.

6. Un dispositif à circuits intégrés selon l'une quelconque des revendications 1 à 5, caractérisé en ce que lesdits moyens (106) pour accepter lesdits deuxièmes signaux d'entrée au niveau de ladite deuxième famille logique, pour produire des quatrièmes signaux internes, comporte des moyens (106) pour coupler directement lesdits deuxièmes signaux d'entrée auxdits deuxièmes moyens de circuits.

7. Un dispositif à circuits intégrés selon l'une quelconque des revendications 1 à 5, caractérisé en ce que les moyens (106) pour accepter les deuxièmes signaux d'entrée au niveau de ladite deuxième famille logique pour produire des quatrièmes signaux internes, comporte des moyens de circuits tampon.

8. Un dispositif à circuits intégrés selon l'une quelconque des revendications 1 à 7, caractérisé en ce que lesdits moyens (113) pour fournir des deuxièmes signaux de sortie au niveau de ladite deuxième famille logique en réponse auxdits sixièmes signaux internes, comporte des moyens pour traduire lesdits sixièmes signaux du niveau de ladite première logique au niveau de ladite deuxième famille logique.

9. Un dispositif à circuits intégrés selon l'une quelconque des revendications 1 à 8, caractérisé en ce que lesdits moyens (111) pour fournir des premiers signaux de sortie au niveau de ladite première famille logique en réponse auxdits cinquièmes signaux internes, comporte des moyens de circuit tampon pour recevoir lesdits cinquièmes signaux internes depuis lesdits premiers moyens de circuit et fournir un signal de sortie externe.

10. Un dispositif à circuits intégrés selon l'une quelconque des revendications 1 à 9, caractérisé en ce que lesdits moyens (109) pour fournir des troisièmes signaux de sortie au niveau de la première famille logique en réponse auxdits septièmes signaux internes, comporte des moyens pour traduire lesdits septièmes signaux internes du niveau de ladite deuxième famille logique au niveau de ladite première famille logique.

11. Un dispositif à circuits intégrés selon l'une quelconque des revendications 1 à 10, caractérisé en ce que lesdits moyens (109) pour fournir des quatrièmes signaux de sortie au niveau de ladite deuxième famille logique en réponse auxdits huitièmes signaux internes, comporte des moyens de circuits tampons pour recevoir lesdits huitièmes signaux internes à partir desdits deuxièmes moyens de circuits er pour fournir des signaux de sortie externes.

12. Un dispositif à circuits intégrés selon l'une quelconque des revendications 1 à 11, caractérisé en ce que ladite première famille logique est une logique transistor-transistor et ladite deuxième famille logique est une logique à couplage d'émetteurs.

13. Un dispositif à circuits intégrés selon l'une quelconque des revendications 1 à 12, caractérisé en ce que chaque moyen de circuits (114, 115) comporte un moyen de circuits logiques.

14. Un dispositif à circuits intégrés selon l'une quelconque des revendications 1 à 12, caractérisé en ce que chaque moyen de circuits (114, 115) comporte des moyens de circuits de mémoire.

15. Un dispositif à circuits intégrés selon l'une quelconque des revendications 1 à 12, caractérisé en ce que chaque moyen de circuits (114, 115) comporte des moyens logiques et des moyens de mémoire.

16. Un dispositif à circuits intégrés selon l'une quelconque des revendications 1 à 15, caractérisé en ce que lesdits moyens (113) pour fournir des deuxièmes signaux de sortie au niveau de ladite deuxième famille logique en réponse auxdits sixièmes signaux internes et/ou lesdits moyens (110) pour accepter lesdits premiers signaux d'entrée au niveau d'une première famille logique pour produire des deuxièmes signaux internes au niveau d'une deuxième famille de niveau logique, comporte un traducteur de TTL en ECL comprenant:

un transistor (32) de source à courant constant ayant son émetteur connecté à la terre TTL (28);

une première paire de transistor bipolaires (30, 31) ayant leurs émetteurs connectés en commun au collecteur dudit transistor (32) de source de courant constant, la base d'un transistor (31) ayant une tension de référence fixée qui lui est appliquée et la base de l'autre transistor (30) étant couplée à la ligne (29) d'entrée TTL desorte que ladite paire de transistors bipolaires (30, 31) conduit de manière différente suivant que le niveau d'entrée TTL est au-dessus ou au-dessous de la tension de référence fixée;

une deuxième paire de transistors bipolaires (34, 35) ayant leurs bases connectées aux collecteurs respectifs des transistors de ladite première paire de transistors bipolaires (30, 31) et ayant leurs collecteurs connectés à TTL $V_{cc}$ et ayant leurs émetteurs connectés à travers des résistances en série respectives (56, 60, 57, 62) à la ligne (67) ECL $V_{EE}$;

une troisième paire de transistors bipolaires (36, 37) ayant leurs émetteurs connectés en commun au collecteur dudit deuxième transistor de source de courant (38) et ayant leurs bases connectées respectivement aux émetteurs respectifs des transistors de ladite deuxième paire de transistors bipolaires (34, 35); et

une paire de transistors de sortie (41, 42) ayant leurs bases connectées aux collecteurs respectifs des transistors de ladite troisième paire de transistors bipolaires (36, 37), leurs collecteurs étant connectés en commun à la terre ECL (68) et leurs émetteurs connectés à travers des moyens de stabilisation de courant (39, 40) à ECL $V_{EE}$ (67), les émetteurs de ladite paire de transistors de sortie (41, 42) servant de sorties ECL inverseuse et non-inverseuse.

17. Un dispositif à circuits intégrés selon l'une quelconque des revendications 1 à 16, caractérisé en ce que lesdits moyens (108) pour accepter des deuxièmes signaux d'entrée au niveau de ladite deuxième famille logique, pour produire des troisièmes signaux internes au niveau de ladite première famille logique et/ou lesdits moyens (107) pour fournir des troisièmes signaux de sortie au niveau de la première famille logique en réponse auxdits septièmes signaux internes, comportent un traducteur de ECL en TTL comprenant:

un transistor (72) de source à courant constant ayant son émetteur connecté au niveau de référence (84) ECL $V_{EE}$ et sa base connectée à une tension capacitive de référence $V_{CS}$ (98);

une paire de transistors bipolaires (70, 71) ayant leurs émetteurs connectés en commun au collecteur dudit transistor (72) de source à courant constant et ayant leurs collecteurs connectés respectivement à la terre ECL (86) et à un circuit de contrôle différentiel, ledit circuit de contrôle différentiel comportant;

un transistor de sortie (77) de rappel à la source ayant son émetteur connecté à la ligne (98) de sortie TTL et son collecteur connecté à TTL V<sub>cc</sub> (82);

un transistor de sortie (78) de rappel à la masse ayant son collecteur connecté à la ligne (98) de sortie TTL et son émetteur connecté à la terre TTL (83);

un premier transistor de commande de base (76) ayant son émetteur connecté à la base dudit transistor (77) de sortie de rappel à la source et ayant son collecteur connecté au collecteur dudit transistor (77) de sortie de rappel à la source;

un deuxième transistor de commande de base (75) ayant son émetteur connecté à la base dudit transistor (78) de sortie de rappel à la masse et ayant son collecteur connecté à TTL V<sub>cc</sub> (82) à travers la résistance (91) et à la base du transistor (76) de sortie de rappel à la source à travers une diode (80); et

des moyens qui en réponse au courant provenant dudit transistor (72) de source à courant constant, qui circule à travers l'un de ladite paire de transistors bipolaires (70, 71), connectés audit circuit de commande différentiel pour bloquer ou débloquer ledit premier transistor (76) de commande de base, entraînant de la sorte le déblocage ou la blocage dudit second transistor (75) de commande de base pour un rappel à la source ou un rappel à la terre dudit niveau de sortie TTL suivant un niveau d'entrée ECL appliqué à la base d'au moins un des transistors (70, 71) de ladite paire de transistors bipolaires.

FIG. 1

FIG. 2

2

FIG. 3

FIG. 4